## Europäisches Patentamt
## European Patent Office
## Office européen des brevets

(19)

(11) Veröffentlichungsnummer: **0 123 715**
**B1**

(12)

# EUROPÄISCHE PATENTSCHRIFT

(45) Veröffentlichungstag der Patentschrift:
**16.09.87**

(51) Int. Cl.⁴: **H 03 J 9/00, H 04 Q 9/00,**
**G 06 F 3/02, H 03 M 5/00**

(21) Anmeldenummer: **83107427.3**

(22) Anmeldetag: **28.07.83**

(54) **Elektronisches Gerät mit einer Einrichtung zur Tastenabfrage von Funktionstasten.**

(30) Priorität: **02.04.83 DE 3312153**

(43) Veröffentlichungstag der Anmeldung:
**07.11.84 Patentblatt 84/45**

(45) Bekanntmachung des Hinweises auf die Patenterteilung:
**16.09.87 Patentblatt 87/38**

(84) Benannte Vertragsstaaten:
**DE FR GB IT**

(56) Entgegenhaltungen:
**DE - A - 3 109 119**
**DE - B - 2 348 517**
**DE - B - 2 538 294**
**US - A - 4 015 254**
**US - A - 4 129 886**

(73) Patentinhaber: **GRUNDIG E.M.V. Elektro-Mechanische Versuchsanstalt Max Grundig holländ. Stiftung & Co. KG., Kurgartenstrasse 37, D-8510 Fürth (DE)**

(72) Erfinder: **Schuelein, Reinhard, Humboldtstrasse 6, D-8502 Zirndorf (DE)**

## Beschreibung

Die Erfindung betrifft ein elektronisches Gerät mit einer Einrichtung zur Tastenabfrage von Funktionstasten, deren Betätigung an einem stromgespeisten Widerstandsnetzwerk jeweils einen für die betätigte Taste charakteristischen Spannungsabfall hervorruft, der über einen Analog-Digital-Umsetzer abgetastet und über eine Auswerteeinrichtung ausgewertet wird.

Es sind bereits Einrichtungen zur Tastenerkennung in Verbindung mit Fernbedienungen bekannt. Hierbei wird der unterschiedliche Spannungsabfall, der durch Einschalten eines oder mehrerer Widerstände in einen Stromkreis entsteht, abgetastet und ausgewertet. Eine solche Einrichtung ist zum Beispiel in der US-A-4 015 254 beschrieben. Mit der bekannten Einrichtung ist es ohne zusätzliche Kontakte an den Tasten jedoch nicht möglich, mit einer Tastenbetätigung auch jeweils die gesamte Stromversorgung des elektronischen Gerätes einzuschalten.

Der Erfindung liegt die Aufgabe zugrunde, ein elektronisches Gerät der im Oberbegriff des Anspruchs 1 angegebenen Art so auszubilden, dass ohne zusätzliche Einschalter und ohne zusätzliche Kontakte an den Tasten durch Drücken einer Taste die gesamte Spannungsversorgung des Gerätes eingeschaltet wird.

Diese Aufgabe wird gemäss der Erfindung durch die im Kennzeichen des Anspruches 1 angegebenen Merkmale gelöst. Vorteilhafte Ausgestaltungen der Erfindung sind in den Unteransprüchen gekennzeichnet.

Bei dem elektronischen Gerät gemäss der Erfindung wird auf einfache Art und Weise durch Drücken einer Funktionstaste auch die gesamte Spannungsversorgung des Gerätes eingeschaltet. Insbesondere bei tragbaren und somit meist batteriebetriebenen Geräten bietet diese Art der Bedienung den Vorteil, dass der Batterie nur Energie entzogen wird, solange eine Geräte- bzw. Bedienungsfunktion besteht. Hierzu ist das an sich bekannte Widerstandsnetzwerk mit der Spannungsversorgungsquelle des elektronischen Gerätes und dem Steuereingang einer ersten Schalteinrichtung gleichstrommässig so verbunden, dass die Betätigung einer Funktionstaste einen Steuerstrom auslöst, der die Schalteinrichtung aktiviert und die Anschaltung der Spannungsversorgungsquelle an den Versorgungseingang des elektronischen Gerätes bewirkt. Ferner ist eine zweite Schalteinrichtung vorgesehen, die, gesteuert von dem Analog-Digital-Umsetzer und der Auswerteeinrichtung, die erste Schalteinrichtung so lange im aktivierten Zustand hält, bis die über die betätigte Funktionstaste gewählte Gerätefunktion ausgeführt ist.

Ein Ausführungsbeispiel der Erfindung wird im folgenden anhand einer Zeichnung näher erläutert.

Es zeigen:

Fig. 1 eine bekannte Einrichtung zur Tastenabfrage;

Fig. 2 eine Einrichtung zur Tastenabfrage für ein elektronisches Gerät gemäss der Erfindung.

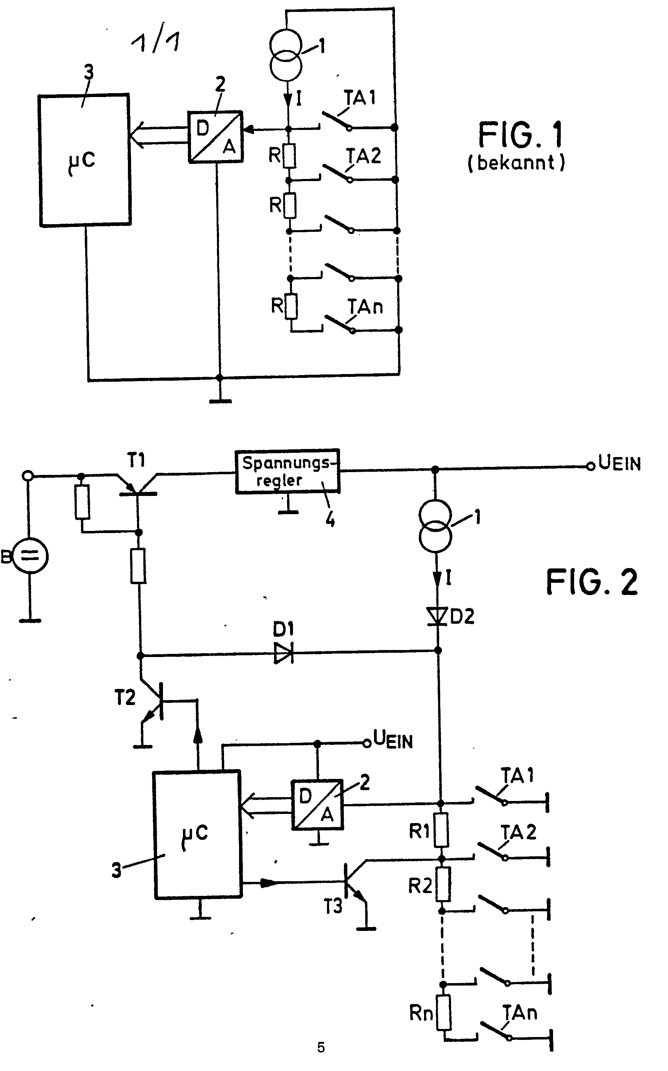

Gemäss Fig. 1 wird der entstehende unterschiedliche Spannungsabfall beim wahlweisen Zuschalten (mittels Funktionstasten TA 1, TA 2, ... TA n) von einem Strom I einer Stromquelle 1 durchflossenen Widerständen R über einen Analog-Digital-Umsetzer 2 einer Auswerteeinrichtung bzw. Recheneinheit 3 zugeführt und dort abgetastet und ausgewertet.

Wird demgegenüber bei der erfindungsgemässen Schaltungsanordnung zur Tastenabfrage mit Einschaltfunktion gem. Fig. 2 eine der Funktionstasten TA 1 ... TA n betätigt, so entsteht über eine, zwischen den Funktionstasten TA 1 ... TA n bzw. den Widerständen R 1, R 2, ... Rn (vorzugsweise gleich gross, also R 1 = R 2 = ... R n = R) und einen mit der Versorgungsspannung $U_B$ verbundenen Transistor T 1 zwischengeschaltete Diode D 1 ein Basisstrom im Transistor T 1, der wiederum die gesamte Spannungsversorgung einschaltet.

Die wie in Fig. 1 über einen Analog-Digital-Umsetzer 2 mit den Widerständen R 1, R 2, ... R n verbundene Auswerteeinrichtung bzw. Recheneinheit 3 hält über einen zwischen den Transistor T 1 und die Auswerteeinrichtung 3 geschalteten Transistor T 2 die Spannungsversorgung aufrecht und sperrt die Diode D 1. Über eine Diode D 2, die anodenseitig mit der Stromquelle 1 und kathodenseitig mit den Widerständen R 1, R 2, ... R n bzw. der Kathode der Diode D 1 verbunden ist, werden nun die Funktionstasten TA 1 ... TA n (Tastatur) mit einem Konstantstrom versorgt, so dass die Auswerteeinrichtung 3 die gedrückte Taste erkennen kann und die entsprechende Funktion auslöst. Nach Beendigung der Funktion schaltet die Auswerteeinrichtung 3 (beispielsweise ein Mikrocomputer) über den Transistor T 2 selbständig die gesamte Spannungsversorgung wieder ab.

Ein Transistor T 3 ist zwischen die Auswerteeinrichtung 3 und die Widerstände R 1, R 2, ... R n geschaltet. Mit Hilfe dieses Transistors T 3 kann die Auswerteeinrichtung 3 den Temperaturgang und die Toleranz der Stromquelle 1 abtasten und bei der Tastenerkennung berücksichtigen.

Die Schaltungsanordnung gemäss Fig. 2 vervollständigt ein zwischen den Transistor T 1 und die Stromquelle 1 geschalteter Spannungsregler 4.

Parallel zu den Funktionstasten TA 1, TA 2, ... TA n kann vorteilhafterweise eine weitere Anordnung von Funktionstasten, beispielsweise einer (drahtgebundenen) Fernbedienungseinrichtung, geschaltet sein (nicht dargestellt).

## Patentansprüche

1. Elektronisches Gerät mit einer Einrichtung zur Tastenabfrage von Funktionstasten, deren Betätigung an einem stromgespeisten Widerstandsnetzwerk jeweils einen für die betätigte Taste charakteristischen Spannungsabfall hervorruft, der über einen Analog-Digital-Umsetzer abgetastet und über eine Auswerteeinrichtung ausgewertet wird, dadurch gekennzeichnet, dass das Widerstandsnetzwerk (R 1, . . . R n) mit der Spannungsversorgungsquelle (U$_B$) des elektronischen Geräts und dem Steuereingang einer ersten Schalteinrichtung (T 1) gleichstrommässig so verbunden ist, dass die Betätigung einer Funktionstaste (TA 1, . . . TA n) einen Steuerstrom auslöst, der die Schalteinrichtung (T 1) aktiviert und die Anschaltung der Spannungsversorgungsquelle (U$_B$) an den Versorgungseingang (U$_{EIN}$) des elektronischen Gerätes bewirkt, und dass eine zweite Schalteinrichtung (T 2) vorgesehen ist, die, gesteuert von dem Analog-Digital-Umsetzer (2) und der Auswerteeinrichtung (3), die erste Schalteinrichtung (T 1) so lange im aktivierten Zustand hält, bis die über die betätigte Funktionstaste gewählte Gerätefunktion ausgeführt ist.

2. Elektronisches Gerät nach Anspruch 1, dadurch gekennzeichnet, dass die das Widerstandsnetzwerk (R 1, . . . R n) speisende Stromquelle (1) mit dem Versorgungseingang (U$_{EIN}$) des elektronischen Gerätes verbunden ist und erst mit dem Anschalten der Spannungsversorgungsquelle (U$_B$) aktiviert wird.

3. Elektronisches Gerät nach Anspruch 2, dadurch gekennzeichnet, dass die Speisung des Widerstandsnetzwerks (R 1, . . . Rn) durch die Stromquelle (1) über eine Diode (D 2) erfolgt.

4. Elektronisches Gerät nach einem oder mehreren der Ansprüche 1 bis 3, dadurch gekennzeichnet, dass als gleichstrommässige Verbindung zwischen dem Steuereingang der ersten Schalteinrichtung (T 1) und dem Widerstandsnetzwerk (R 1, . . . R n) eine Diode (D 1) in Flussrichtung geschaltet ist.

5. Elektronisches Gerät nach einem oder mehreren der Ansprüche 1 bis 4, dadurch gekennzeichnet, dass zur Überwachung des Temperaturganges der Stromquelle (1) zwischen dem Widerstandsnetzwerk (R 1, . . . R n) und der Auswerteeinrichtung (3) ein von der Auswerteeinrichtung steuerbarer Transistor geschaltet ist.

6. Elektronisches Gerät nach einem oder mehreren der Ansprüche 1 bis 5, dadurch gekennzeichnet, dass als Schalteinrichtungen (T 1, T 2) Transistoren vorgesehen sind.

7. Elektronisches Gerät nach einem oder mehreren der Ansprüche 1 bis 6, dadurch gekennzeichnet, dass als Auswerteeinrichtung (3) ein Mikrocomputer vorgesehen ist.

8. Elektronisches Gerät nach einem oder mehreren der Ansprüche 1 bis 7, dadurch gekennzeichnet dass parallel zu den Funktionstasten (TA 1, . . . TA n) eine weitere Anordnung von Funktionstasten, beispielsweise einer Fernbedienungseinrichtung, geschaltet ist.

## Revendications

1. Appareil électronique avec un dispositif d'interrogation de touches de fonctions, dont l'actionnement provoque une chute de tension caractéristique pour la touche actionnée sur un réseau de résistances alimenté en courant, qui est exploré au moyen d'un convertisseur analogique-numérique et évalué au moyen d'un dispositif d'analyse, caractérisé en ce que le réseau de résistances (R 1, . . . R n) est relié en courant continu à la source d'alimentation en tension U$_B$ de l'appareil électronique et à l'entrée de commande d'un premier organe de couplage (T 1), de telle sorte que l'actionnement d'une touche de fonctions (TA 1, . . . TA n) déclenche un courant de commande, qui active l'organe de couplage (T1) et provoque la connexion de la source d'alimentation en tension (U$_B$) à l'entrée d'alimentation (U$_E$) de l'appareil électronique, et en ce qu'il est prévu un deuxième organe de couplage (T 2) qui, commandé par le convertisseur analogique-numérique (2) et par le dispositif d'analyse (3) maintient en état d'activité le premier dispositif de couplage (T 1) jusqu'à ce que la fonction sélectionnée sur l'appareil par la touche de fonction actionnée ait été exécutée.

2. Appareil électronique selon la revendication 1, caractérisé en ce que la source de courant (1) qui alimente le réseau de résistances (R 1, . . . R n) est reliée à l'entrée d'alimentation (U$_E$) de l'appareil électronique et n'est activée qu'au moment du branchement de la source d'alimentation en tension (U$_B$).

3. Appareil électronique selon la revendication 2, caractérisé en ce que l'alimentation du réseau de résistances (R 1, . . . R n) est assurée par la source de courant (1), par l'intermédiaire d'une diode (D 2).

4. Appareil électronique selon une ou plusieurs des revendications 1 à 3, caractérisé en ce qu'une diode (D 1), constituant une connexion en courant continu, est intercalée dans le sens de circulation du courant, entre l'entrée de commande du premier organe de couplage ( T 1) et le réseau de résistance (R 1, . . . R n).

5. Appareil électronique selon une ou plusieurs des revendications 1 à 4, caractérisé en ce qu'il est monté, entre le réseau de résistances (R 1, . . . R n) et le dispositif d'analyse (3), un transistor susceptible d'être commandé par le dispositif d'analyse (3), pour assurer la surveillance de l'allure de la température de la source de courant (1).

6. Appareil électronique selon une ou plusieurs des revendications 1 à 5, caractérisé en ce que des transistors (T 1, T 2) sont prévus comme organe de couplage.

7. Appareil électronique selon une ou plusieurs des revendications 1 à 6, caractérisé en ce qu'un micro-ordinateur est prévu comme dispositif d'analyse (3).

8. Appareil électronique selon une ou plusieurs des revendications 1 à 7, caractérisé en ce qu'une autre disposition de touches de fonctions, par exemple un dispositif de commande à distance, est montée en parallèle avec les touches de fonction (TA 1, . . . TA n).

## Claims

1. Electronic unit comprising a device for scanning function keys the actuation of which in each case causes a voltage drop characteristic of the actuated key across a current-fed resistance network, which voltage drop is scanned via an analogue/digital converter and evaluated via an evaluating device, characterized in that the resistance network (R 1, ... R n) is direct-current-connected to the voltage supply source (U$_B$) of the electronic unit and to the control input of a first switching device (T 1) in such a manner that the actuation of a function key (TA 1, ... TA n) releases a control current which activates the switching device (T 1) and effects the connection of the voltage supply source (U$_B$) to the supply input (U$_{EIN}$) of the electronic unit, and that a second switching device (T 2) is provided which, controlled by the analogue/digital converter (2) and the evaluation device (3), keeps the first switching device (T 1) in the activated state until the device function selected via the function key actuated has been executed.

2. Electronic unit according to Claim 1, characterized in that the current source (1) feeding the resistance network (R 1, ... R n) is connected to the supply input (U$_{EIN}$) of the electronic unit and is activated only when the voltage supply source (U$_B$) is switched on.

3. Electronic unit according to Claim 2, characterized in that the resistance network (R 1, ... R n) is fed by the current source (1) via a diode (D 2).

4. Electronic unit according to one or more of Claims 1 to 3, characterized in that a diode (D 1) is connected in the direction of current flow as direct-current connection between the control input of the first switching device (T 1) and the resistance network (R 1, ... R n).

5. Electronic unit according to one or more of Claims 1 to 4, characterized in that a transistor which is controllable by the evaluation device is connected between the resistance network (R 1, ... R n) and the evaluation device (3) for monitoring the temperature variation of the current source (1).

6. Electronic unit according to one or more of Claims 1 to 5, characterized in that transistors are provided as switching devices (T 1, T 2).

7. Electronic unit according to one or more of Claims 1 to 6, characterized in that a microcomputer is provided as evaluation device (3).

8. Electronic unit according to one or more of Claims 1 to 7, chracterized in that another arrangement of function keys, for example of a remote-control device, is connected in parallel with the function keys (TA 1, ... TA n).

1/1

FIG. 1
(bekannt)

FIG. 2

5